(19) Europäisches Patentamt
European Patent Office
Office européen des brevets

(11) **EP 1 675 258 A1**

(12) **EUROPEAN PATENT APPLICATION**

(43) Date of publication:
28.06.2006 Bulletin 2006/26

(51) Int Cl.:
*H03G 9/02* (2006.01)

(21) Application number: 05257948.9

(22) Date of filing: 21.12.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 23.12.2004 US 22182

(71) Applicant: BBE Sound, Inc.
Huntington Beach
California 92649 (US)

(72) Inventor: Gagon, Paul R.
Hunting Beach
CA 92649 (US)

(74) Representative: Jenkins, Richard Gavin et al
Marks & Clerk
43 Park Place
GB-Leeds LS1 2RY (GB)

(54) **Three-channel state-variable compressor circuit**

(57) An all-pass state-variable filter processes an input program signal into low, middle and high frequency band signals. The middle frequency band signal has an additional inversion stage with respect to the low frequency and high frequency band signals. A first, second and third SDC (Scaled Detector Circuits) each have an input coupled to receive a respective frequency band signal and function to buffer, rectify and filter its respective frequency band signal to form a control voltage at its output. A first, second and third VCA (Voltage Control Amplifier) receives respective frequency band signals. Each VCA has a control voltage input. Each VCA reduces its gain in response to an increase in the control voltage applied to its control voltage input from an SDC output.

FIG. 1

Printed by Jouve, 75001 PARIS (FR)

**Description**

**FIELD OF THE INVENTION**

This invention relates to the field of electronic amplifiers and more particularly to the field of signal conditioning circuits used in audio amplifiers for the purpose of reproducing music and delivering it to a speaker or other reproduction means.

<u>CROSS REFERENCE TO RELATED APPLICATIONS</u>

This application provides information that relates to the subject mater found in S/N 08/377,903 filed 01/24/95 for "A LOW INPUT SIGNAL BANDWIDTH COMPRESSOR AND AMPLIFIER CONTROL CIRCUIT" which issued on April 23, 1996 as U.S. Patent 5,510,752; and, to S/N 09/636,168 filed April 22, 1996 for "A LOW INPUT SIGNAL BANDWIDTH COMPRESSOR AND AMPLIFIER CONTROL CIRCUIT WITH A STATE VARIABLE ALL-PASS STATE VARIABLE FILTER" which issued on April 7, 1998 as U.S. Patent 5,736,897; S/N 09/444,541 filed 11/22/99 for "AN AUDIO BOOST CIRCUT"; and from a non-provisional application S/N 10/923,461 filed 08/20/04 based upon the prior provisional application Ser. No. 60/497,095 filed August 22, 2003 for "HARMONIC GENERATOR AND PRE-AMP". All of the references cited here have a common inventor and assignee. All of the applications mentioned above are incorporated herein by reference in their entirety.

<u>BACKGROUND OF THE INVENTION</u>

The above referenced patent 5,736,897 shows a state-variable filter used as an All-Pass State Variable Filter that receives an input program signal and processes the input program signal to provide three band-pass signals comprising a low band-pass signal (LFRIPS), a mid-range band pass signal (MFRIPS) and a high band-pass signal (HFRIPS) to respective inputs of a summing amplifier. The three signal components are then summed and output as a compensated signal at its output. The '897' Patent then shows the compensated signal being processed by a "Compander" Circuit first introduced in the above referenced U.S. Patent 5,510,752. The Compander circuit of the 897 reference uses the same voltage controlled amplifier used in the present application, but the Compander Circuit has a feed-back loop to shift the center frequency of the Composite Output Signal. The present invention circuit uses three voltage controlled amplifiers to control the gain of three respective channels but they are not designed to control the bandwidth or center frequencies of the channels and a Compander Circuit is not used. Application S/N 09/444,541 referenced above shows the compensated signal at the output of the state-variable filter driving an audio boost circuit.

In the reproduction of music, a repeated loud sound occurring within the reproduction is an effect that a listener may sometimes choose to suppress or attenuate. Such a sound is typically much larger and therefore louder than the average tones forthcoming from the presentation. The periodic sound of a large drum is an example of such a sound which occurs in the low frequency band. A periodic crashing of symbols provides an example of a pulse of sound at the high frequency end of the audio range. Sounds that are dramatically louder than the average level of a musical score can be compensated for by an automatic gain control or attenuation; however, if the attenuation provided by the automatic gain control is broadband across the audio spectrum, information that need not have been suppressed is lost along with the high amplitude disturbance.

<u>SUMMARY OF THE INVENTION</u>

The above-noted problems, and others, are overcome by use of the Three Channel State Variable Compressor Circuit taught herein. In accordance with an embodiment of the invention a Three Channel State Variable Compressor Circuit is used to detect relatively large disturbances and to automatically suppress such disturbances by reducing the electronic gain of the amplifier processing the disturbance. In accordance with other embodiments a received program signal containing a disturbance is processed with an all pass state-variable filter into three frequency bands which include a high frequency band, a mid frequency band and a low frequency band, the band in which a loud sound is dominant is automatically detected to attenuate the gain of that channel independently of the other two channels. In accordance with another embodiment, incidents of loud sounds are selectively detected and attenuated without the necessity of the disturbance or loud sound being periodic. The spectral power of a disturbance or loud sound is processed in one or more of the three channels or frequency bands that are the output of the all pass filter depending on the frequency band in which the spectral energy of the disturbance or loud sound resides.

**BRIEF DESCRIPTION OF THE DRAWINGS**

Details of the invention, and of preferred embodiments thereof, will be further understood with reference to the following drawings, wherein:

FIG. 1 is a block diagram of the Three Channel State Variable Compressor Circuit,

FIG. 2 is a schematic of the All-Pass State Variable Filter for providing three separate signal comprising a high-frequency band signal, a mid-frequency band signal and a low frequency band signal,

FIG. 3 is a schematic of the Three-Channel Scaling and Detector Circuit;

FIG. 4 is a schematic of the Three-Channel Voltage Control Amplifier and Summing Circuit , and

FIG. 5a is a schematic block diagram of a digital system for digitally modeling the SDC and VCA portions of the Three-Channel Voltage Control Amplifier and Summing Circuit;

FIG. 5b is a schematic block diagram of a digital system for digitally modeling the State-Variable Filter, the SDC and the VCA portions of the Three-Channel Voltage Control Amplifier and Summing Circuit.

**DETAILED DESCRIPTION OF PREFERRED EMBODIMENTS**

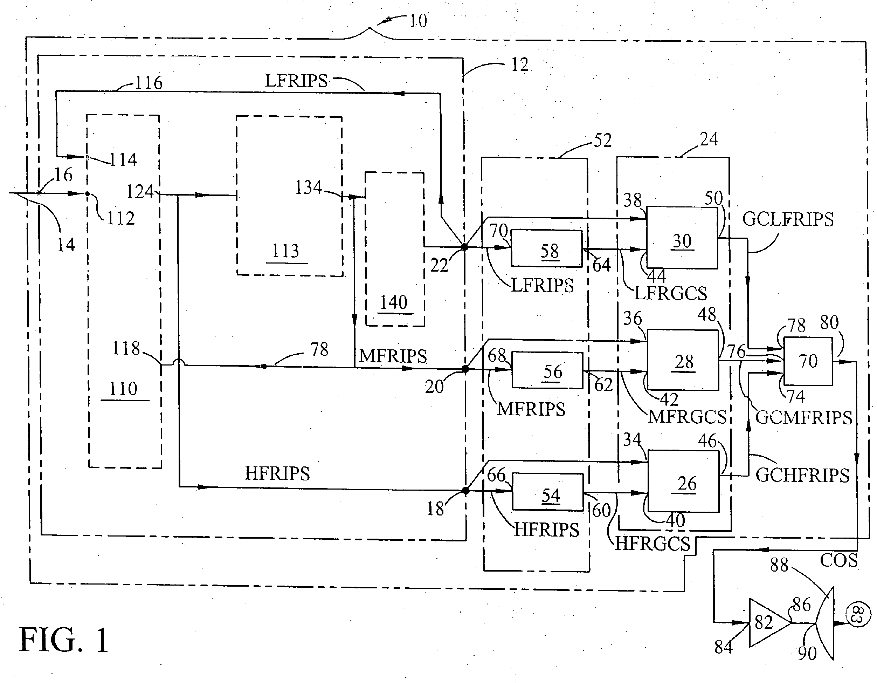

Figure 1 is a block diagram of the Three Channel State Variable Compressor Circuit 10. Phantom block 12 represents an All-Pass (or Three-Channel) State-Variable Filter that has an input coupled to receive and process an IPS (input program signal) which arrives via signal line 14 at input terminal 16. The IPS signal is typically a low-level initial source broad-band audio signal such as the signal emanating from the stylus of a record changer, or the read-head, or pick-off, of a tape, disk or solid state recorder (e.g., an MP3 player or the like).

The state-variable filter processes the IPS into three frequency range input program signals that are output at terminals 18, 20 and 22. Each respective output signal contains a band-width limited portion of the IPS having spectral information from the input IPS that is limited to a predetermined frequency band or range within the overall frequency spectrum of the IPS. The three signals include a HFRIPS (High Frequency Range Input Program Signal) at output terminal 18, an MFRIPS (Mid-Frequency Range Input Program Signal) at output terminal 20 and a LFRIPS (Low-Frequency Range Input Program Signal) at output terminal 22.

Phantom block 24 encloses a Three-Channel VCA (Voltage Controlled Amplifier) containing a first, second and third VCA (Voltage Controlled Amplifier) circuit 26, 28, 30. Each of the three VCA circuits has a VCA signal input 34, 36, 38, a VCA control signal input, 40, 42, 44 and a respective VCA output, 46, 48, 50.
Phantom block 52 encloses a Three-Channel SDC (Scaled Detector Circuit). The three SDC Circuits are the High Frequency SDC 54, the Mid-Frequency SDC 56 and the Low-Frequency SDC 58. Each of the three SDC circuits within phantom block 52 are connected to sample, scale, rectify and filter one of the three output signals of the Three Channel State Variable Filter 12. The High Frequency SDC 54 is connected to sample the HFRIPS at terminal 18. The Mid-Frequency SDC 56 is connected to sample the MFRIPS at terminal 20. The Low-Frequency SDC 58 is connected to sample the LFRIPS at terminal 22.

After processing the HFRIPS, the High Frequency SDC 54 outputs an HFRGCS (High-Frequency Range Gain Control Signal) from its output 60 to the first VCA control signal input at terminal 40. The Mid-Frequency SDC 56 outputs an MFRGCS (Mid-Frequency Range Gain Control Signal) from its output 62 to the second VCA control signal input at terminal 42. After processing the LFRIPS, a Low-Frequency SDC 58 outputs the LFRGCS (Low-Frequency Range Gain Control Signal) from its output 64 to the third VCA control signal input at terminal 44.

Returning again to phantom block 24, the first VCA signal input 34 is connected to the HFRIPS at terminal 18. The second VCA signal input 36 is connected to the MFRIPS at terminal 20. The third VCA signal input 38 is connected to the LFRIPS at terminal 22 .

The first. second and third VCA respond to their respective Gain Control Signals at their respective gain control inputs 40, 42, 44, and to their corresponding HFRIPS, the MFRIPS and the LFRIPS at their signal inputs 34, 36, 38 to provide three output signals which include a GCHFRIPS (Gain Controlled High-Frequency Range Input Program Signal) at first VCA output 46, a GCMFRIPS (Gain Controlled Mid-Frequency Range Input Program Signal) at second VCA output 48 and a GCLFRIPS (Gain Controlled Low-Frequency Range Input Program Signal) at third VCA output 50.

Block 70 represents a summing circuit with a first input 74, a second input 76 and a third input 78. Each respective summing circuit input is coupled to a corresponding VCA first, second or third output 46, 48, 50 to add and provide the sum of the GCHFRIPS, the GCMFRIPS and the GCLFRIPS signals and to output the sum of those signals as the COS (Composite Operating Signal) at a Summing Circuit Output 80.

Block 82 represents a power amplifier with its input 84 coupled to the summing amplifier output 80 to receive the COS. The power amplifier output 86 is coupled to the speaker 88 at the speaker signal input 90. The speaker 88 uses the output signal from the power amplifier output 86 to produce an output program signal with loud or transient disturbances suppressed by the Three-Channel State-Variable Compressor Circuit 10.

**All-Pass State-Variable Filter Design**

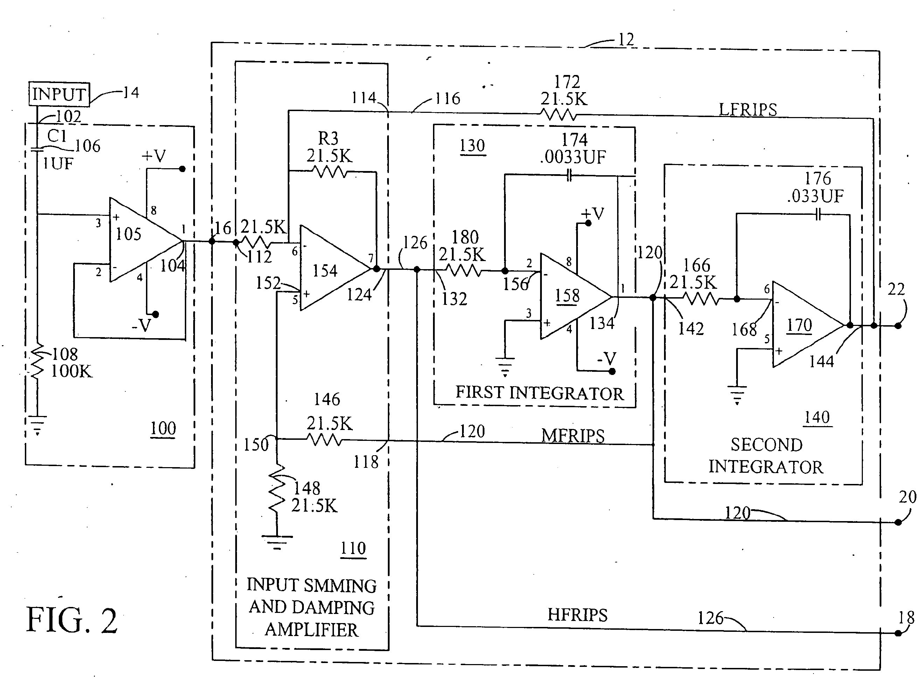

Referring now to Figure 2, phantom block 100 represents a unity gain voltage follower that serves as a buffer amplifier and provides impedance matching to the normal IPS signal at signal line 14 from sources such as, but not limited to, recorders, record changers, DVDs and CD changers and the like (not shown). The Buffer amplifier receives an input at its input terminal 102. The buffer amplifier output 104 is connected to the All-Pass State Variable Filter input terminal 16. Operational amplifier 105 is typically an amplifier that is equivalent to the Texas Instrument TL072. Unity gain is provided by the connection between the amplifier output at pin 1 and its inverting input at pin 2. Capacitor 106 blocks any dc on the signal input and resistor 108 references the input signal to ground.

The All-Pass State Variable Filter within phantom block 12 has an Input Summing And Damping Amplifier within phantom block 110. The Input Summing And Damping Amplifier has a first input 112 coupled to receive the IPS from the All-Pass State Variable Filter Input 16. A second input 114 is coupled to receive the LFRIPS from signal line 116, and a third input 118 is coupled to receive the MFRIPS from signal line 120. The Input Summing And Damping Amplifier 110 provides the HFRIPS as its output at terminal 124 via signal line 126 to the first output of the All-Pass State-Variable Filter output terminal 18.

In a more detailed embodiment, the All-Pass State Variable Filter 12 is further characterized as having a First Integrator 130 having an input 132 coupled to receive the HFRIPS from the Input Summing And Damping Amplifier output 110 via signal line 126. The First Integrator has an Output 134 that provides the MFRIPS to the third input 118 of the Input Summing And Damping Amplifier 110 via signal line 120.

A Second Integrator 140 has input 142 coupled to receive the MFRIPS from the First Integrator Output 134. The Second Integrator 140 also has an Output 144 that outputs the LFRIPS onto signal line 116. The MFRIPS is inverted in phase with respect to the HFRIPS and the LFRIPS signal components due to the inversion of the signals provided by the operational amplifiers used in the All-Pass State Variable Filter 12. The inversion provided to the MFRIPS with respect to the HFRIPS and the LFRIPS is critical to the quality of the music produced by the All-Pass State Variable Filter.

The Input Summing And Damping Amplifier circuit 110 has a resistor divider comprised of a first and second resistor 146, 148. The first and second divider resistors are connected in series between the third input 118 and ground. A portion of the MFRIPS that is received at the third input 118 is tapped off from the intermediate node 150 between the first and second resistors. The portion of the MFRIPS obtained at the intermediate node 150 is coupled to the non-inverting input 152 of amplifier 154 for damping. The output of amplifier 154 is the HFRIPS which is coupled to the negative input 156 of a second operational amplifier 158 within First Integrator 130. The First Integrator 130 inverts and integrates the HFRIPS.

The first integrator 130 integrates the HFRIPS signal to provide the mid-range band-pass signal MFRIPS at first integrator output 134. The mid-range band-pass signal MFRIPS is fed via signal line 120 to the third input (the damping input) 118 of the Input Summing And Damping Amplifier circuit 110, to the mid-range band-pass output 20, and to the Second Integrator input 142. Input resistor 166 couples the MFRIPS to the negative input 168 of a third operational amplifier 170 in the Second Integrator 140.

The Second Integrator 140 integrates the mid-range band-pass signal MFRIPS on signal line 120 to provide the low-frequency range signal LFRIPS at the second integrator output terminal 144. The LFRIPS is coupled to the second input 114 of the Input Summing And Damping Amplifier Circuit 110 via resistor 172 and signal line 116.

The ratio of resistors 146 and 148 within the Input Summing And Damping Amplifier Circuit 110 establish the "Q" of the state-variable filter. The higher the ratio of the resistors 146 and 148, the higher the Q. The Q of the All-Pass State-Variable State Variable Filter 12 of Figures 1, 2 and 3 is typically in the range of 0.5 to 2 for audio applications. One of the objectives of the state-variable filter is to set the phase shift and gains up such that the mid-range band-pass frequency signal are about 180 degrees out of phase with the signal components in the lower frequency band and in the higher frequency band. The ratio of the damping resistors, the gains and break frequencies of the amplifiers and integrator are set for a desired Q and band-pass.

The circuit of the All-Pass State-Variable Filter 12 of Figures 1 and 2 can be adjusted by adjusting component values to obtain a total of 360 degrees of phase shift of the high frequency signal components of the IPS with respect to the low frequency signal components of the input program signal, in frequency space over the range of 0 to 20,000 Hz. The high frequency components gain 360 degrees of phase shift with respect to the low frequency components. The All-Pass State Variable Filter 12 also provides a time delay that is adjusted to obtain about 2.5 ms time delay at 20 Hz. The 20 Hz components are physically delayed in real time by up to 2.5 ms with respect to the high frequency components.

Referring again to Figure 2, and to a reactance chart, a check will show the break frequency for the first integrator 130 to be about 2.24 KHz. The break frequency for the second integrator 140 is about a decade lower at 224 Hz at three dB per octave. The Q of the circuit of Figure 2 is approximated by the following equation:

$$\text{Eq. 1} \qquad Q = (R1 + R2)/3R2 = 0.67$$

where R1 is resistor 146 and R2 is resistor 148 as shown in Figure 2.

Viewing the circuit heuristically, the higher reactance of the smaller capacitance for mid-range band-pass amplifier capacitor 174 (C1 = 0.0033 $\mu$F), within the first integrator 130 sets the gain of the amplifier to higher values at lower frequencies than that of the low range band-pass amplifier within the second integrator 140, which has capacitor 176 (C2 = 0.033$\mu$F). It can also be seen that the first integrator 130 is a single pole filter. The feed back signal MFRIPS to the damping resistors 146, 148 results in a controlled Q in the mid-range frequencies band.

In general, the Q of a band-pass filter is defined as the bandwidth divided by the center frequency. The design of the state-variable filter of Figure 2 is taught in the text "The Active Filter Handbook" by Frank P. Tedeschi, pg 178 - 182, Tab Books Inc. of Blue Ridge Summit, Pa., 17214; however, this reference does not show the three outputs of the State-Variable Filter being connected to a first, second and third Scaled Detector Circuits and also to a first, second and third Voltage Controlled Amplifier to form a three channel compressor circuit.

The object of the design of the All-Pass State-Variable Filter 12 of Figures 1 and 2 is to have a first break frequency at approximately 240 Hz and a second at 2.24 KHz, about a decade away from the first break. The low break $f_c$ is established by the equation:

$$\text{Eq. 2} \qquad f_{c\,=\,1/2\pi RC2}$$

where R and C2 are the value of resistor 166 and capacitor 176. The high frequency break is set by the

$$\text{Eq. 3} \qquad f_{c\,=\,1/2\pi RC1}$$

where the value of R and C1 are those of resistor 180 and capacitor 174 .

Once the Q is selected, the ratio of resistor 154 to resistor 156 can be calculated from the equation. In the case of the All-Pass State-Variable Filter of Figures 1 and 2, a Q of 0.67 was selected by knowing what the desired gain bandwidth response curve would be from the above referenced U.S. Patent 4,638,258. The circuit was modeled using a computer aided analysis program such as SPICE. The break frequencies were estimated from the information in the referenced U.S. Patent 4,638,258. Initial component values were selected based on available components. A reactance chart can be used for a quick approximation of the required remaining value once one of the values are known. The circuit shown had an initial goal of a center frequency at 700 Hz. At the center frequency, the gain of the circuit is about -1 dB or less than 1. Two adjustment pots (not shown) were used to adjust the amplitude of the LFRIPS and the HFRIPS by about 15 dB with the values shown.

The outputs HFRIPS, MFRIPS and LFRIPS of The State-Variable Filter 12 represent three independent state variables. The procedure for adjusting the band-pass and gain as proposed in the above referenced text "The Active Filter Handbook" by Frank P.

Tedeschi, at pages 178 - 182 is to set the value of capacitor 174 and capacitor 176 to be equal and to adjust the ratio of resistors 180 and 166 to obtain the desired Q.

### Three-Channel SDC (Scaled Detector Circuit)

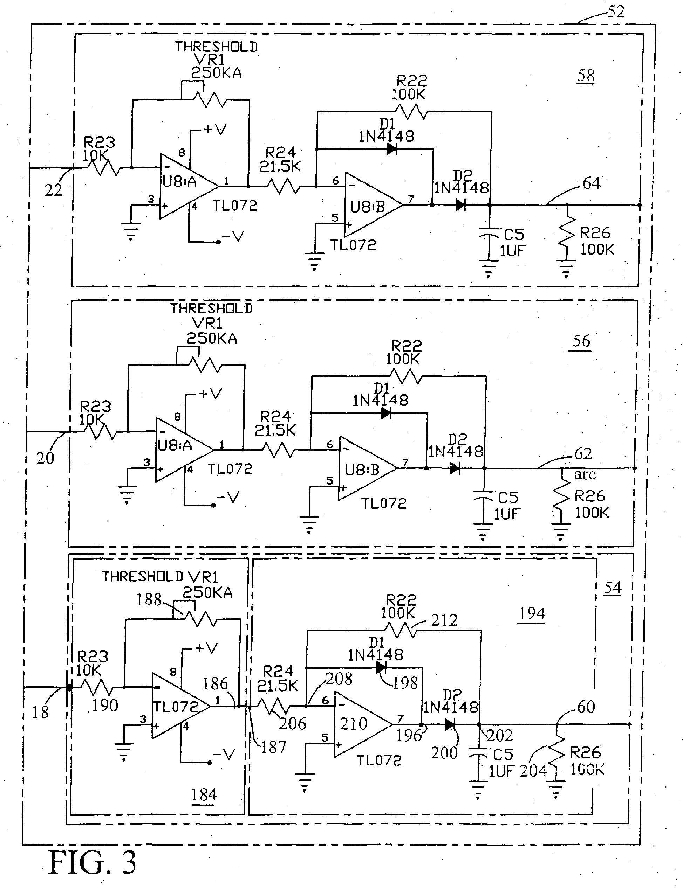

Figure 3 is a schematic of a first, second and third SDC (Scaled Detector Circuit). The circuits are identical in the embodiment shown, so only the bottom circuit or channel within phantom block 54 need be described. The SDC channels within phantom blocks 56 and 58 operate in the same way. Each SDC has an input 18, 20, 22 coupled to receive a respective FRIPS (frequency range input program signal), to scale, rectify and filter the FRIPS to provide a respective first, a second and a third RGCS (Range Gain Control Signal). The inputs 18, 20 and 22 shown on Figure 3 are respectively common with the same nodes shown on Figure 1, 2 and 4.

Phantom box 184 encloses a buffer amplifier that has an input terminal coupled to terminal 18. The buffer amplifier 184 receives the FRIPS signal via terminal 18 and provides an inverted output FRIPS signal at terminal 186. The FRIPS in the case of SDC 54 is the HFRIPS. The buffer amplifier 184 provides amplification to buffer the HFRIPS and to provide a respective BFRIPS (Buffered Frequency Range Input Program signal) to the input 187 of phantom block 194. The signal coupled to input 187 is the HFRBFRIPS (High Frequency Range, Buffered Frequency Range Input Program Signal), The gain of the SDC buffer amplifier within the phantom block 184 circuit is established by the ratio of the variable resistor 188 divided by the value of resistor 190. The parts shown provide for a maximum gain of about 25.

Phantom block 194 in Figure 3 contains the detector portion of the SDC 54 circuit. The circuitry within phantom block 194 is a conventional fast rectifier circuit similar to that characterized in National Semiconductor's Application Notes AN31-11 and it is described in notes LB8-1. The notes characterize the circuit as a high performance precision half wave rectifier and states that when using the LM101A operational amplifier, the circuit provides rectification with a 1 % accuracy over a frequency range extending from zero to 100 kilohertz. As the input voltage at node 186 swings positive, the output of the operational amplifier output 196 swings negative and is immediately clamped by forward biased diode 198 at a forward diode drop below ground. Diode 200 is slightly reverse biased. Capacitor 202 and resistor 204 form a low pass passive filter.

As the voltage at input 187 rises in a positive direction above ground, current enters resistor 206 and attempts to raise the voltage at the negative input to operational amplifier 210 above ground. As the voltage at this node begins to rise, amplifier 210 provides a negative going voltage to node 196 as required to move all of the current that passes into resistor 206 through diode 198 thereby maintaining the voltage at pin 6 of the 210 amplifier at or virtually at ground potential. Essentially all of the current through resistor 206 passes through the resistor to the inverting input 208 of amplifier 210 and is drained off through the forward biased diode 198 and through resistor 212. As the input to terminal 187 swings negative, diode 198 becomes back biased and nonconductive. The output of the amplifier rises in the positive direction and forward biases diode 200 thus providing current to resistor 212, charging current to capacitor 202 and a rise in voltage at output terminal 60 across resistor 204. The voltage at the output 196 of the amplifier 210 rises until the current through resistor 212 equals the current out of the input resistor 206. The gain is the ratio of the resistor 212 divided by the input resistor 206 which in the example of the circuit of phantom block 194 is set to a value of approximately five. It can be seen that the higher the gain, the less significant is the forward drop of diode 200 when a negative going signal is input from node 186. The low pass filter formed by capacitor 202 and resistor 204 smooth the rectified signal which is output on the SDC 54 output terminal 60. The SDC circuit of phantom box 56 has its output at terminal 62, and the SDC circuit of phantom box 58 has its output at terminal 64, each providing a respective first, second and third RGCS (Range Gain Control Signal).

**Three-Channel VCA (Voltage Controlled Amplifier)**

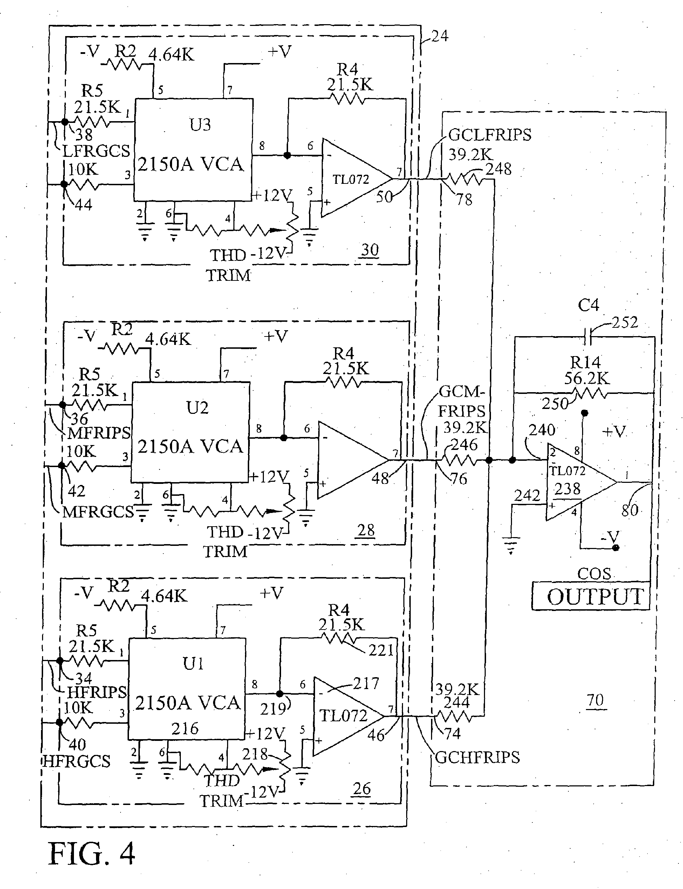

Referring now to Figure 4, phantom block 24 encloses a Three-Channel VCA (Voltage Controlled Amplifier) containing a first, second and third VCA (Voltage Controlled Amplifier) circuit 26, 28, 30. Each of the three VCA circuits has a VCA signal input 34, 36, 38, a VCA control signal input, 40, 42, 44 and a respective VCA output, 46, 48, 50.

Phantom block 24 encloses the Three-Channel VCA (Voltage Controlled Amplifier) shown on Figure 1. The Three-Channel VCA contains a first, second and third VCA (Voltage Controlled Amplifier) circuit 26, 28, 30. Each VCA has a respective signal input 34, 36, 38, coupled to receive a respective FRIPS, a respective control voltage input 40, 42, 44 coupled to receive a respective RGCS, and a respective output 46, 48, 50, to provide a respective first, second and third Gain Controlled Frequency Range Input Program Signal at VCA outputs 46, 48 and 50 respectively. Each VCA is characterized to reduce the gain of the stage in response to an increase in the control voltage applied to its control voltage input 40, 42, 44, while providing a respective GCFRIPS (Gain Controlled Frequency Range Input Program Signal) at its respective outputs such as 46, 48, 50.

Each of the three VCA channel circuits 26, 28, 30, within phantom block 24 are identical. Therefore the VCA circuit within phantom block 26 will be the only one described. In a first alternative embodiment, each VCA uses a type 2150A voltage controlled amplifier 216 available from the THAT Corporation; 734 Forest Street; Marlborough, Massachusetts 01752; USA. VCA 216 has a signal voltage input 34, a control voltage input 40 and as shown in the embodiment of phantom block 46, an output 46. Operational amplifier 217 is configured to operate as a current to voltage converter. The THAT Corporation supplies the VCA component in several configurations, one or more of which permit the use of an external amplifier 217. As shown, amplifier 217 provides an output voltage as required to hold the voltage at node 219 at substantially ground voltage. Current passing from terminal 8 on U1 to the inverting terminal 6 on amplifier results in a negative voltage at terminal 46 of sufficient amplitude to extract all current entering node 219 through resistor 221. The output voltage at 46 is therefore the product of the current to node 219 from pin 8 on VCA 16 times the value of resistor 221.

.The signal voltage input 34 is coupled to receive the HFRIPS from terminal 18. The control voltage input 40 is coupled to receive the HFRGCS from terminal 60 on the SDC 54 on Figure 1 and Figure 3. The GCHFRIPS (Gain Controlled High-Frequency Range Input Program Signal) is output from output terminal 46 to the GCHFRIPS input 74 of Summing Circuit 70.

The THD TRIM adjustments (total harmonic distortion) shown on Figure 4 is typically a variable resistor 218 that is used to trim the current values of two internal current sources within the U2 VCA 2150A. This adjustment is a factory adjustment that typically requires the use of a harmonic distortion analyzer. By adjusting the THD TRIM, values of harmonic distortion as low as 0.02 have been obtained.

## Alternative VCA Circuit

The combination of a light sensitive resistor or photocell with a LED (Light emitting diode is a possible alternative to the 2150A. The LED in such an arrangement would be driven by an input buffer amp (not shown) scaled to convert the RGCS input signal voltage into an LED drive current. The light sensitive resistor or photocell would be in either the input or feed back resistor position in an amplifier circuit (not shown) which would perform the function of the VCA. The signal input to the input buffer would be a respective first, second or third RGCS (Range Gain Control Signal) from a respective SDC such as SDC 54, 56, 58. The output of the signal buffer would drive the LED which would cause the resistance of the light sensitive resistor to change with a change in light output thereby changing the gain of the amplifier. The input to the amplifier would be driven by an input signal such as the HFRIPS, the MFRIPS or the LFRIPS.

As current is increased through the diode, its brightness is increased which reduces the resistance of the photosensitive resistor or photocell. The relationship between the drive current through the diode and the resistance of the photosensitive resistor or photocell is probably not linear. It is believed that noise on the signal would be reduced because a solid state voltage controlled amplifier such as the 2150A has numerous internal diodes, and potentially non-linear components likely to increase the noise on the signal.

## Summing Circuit

Figure 4 contains phantom block 70. The circuit within phantom block 70 is a summing circuit that has a first second and third input 74, 76, 78. The a first second and third inputs are coupled to receive the GCHFRIPS, GCMFRIPS and the GCLFRIPS signals respectively. The summing amplifier 70 adds the GCHFRIPS, GCMFRIPS and the GCLFRIPS signals to form and output the COS (Composite Operating Signal) at the Summing Circuit Output 80. The Summing Circuit 70 has an operational amplifier 238. Operational amplifier 238 has an inverting input 240 and, a non-inverting input 242 coupled to ground and an output terminal 80. A first input resistor 244, a second input resistor 246, a third input resistor 248, and a feedback resistor 250 in parallel with capacitor 252 are used to form Summing Circuit 70. Each of the three resistors has a respective first end and a second end. The Summing Circuit First Input 74 is connected to the first end of the first input resistor 244. The Summing Circuit Second Input 76 is connected to the first end of the second input resistor 246. The Summing Circuit Third Input 74 is connected to the first end of the third input resistor 246. The first end of the feedback resistor 250 is connected to the Summing Circuit Output Terminal 80. The second end of the first input resistor 244, the second end of the second input resistor 246, the second end of the third input resistor 248 and the second end of the feedback resistor 250 are each connected to the operational amplifier inverting input 240. Capacitor 252 in combination with resistor 250 provide a predetermined break frequency and roll off for the COS. The operational amplifier output terminal 80 is the Summing Circuit Output Terminal for the COS (Composite Output Signal).

## Digital Signal Processing

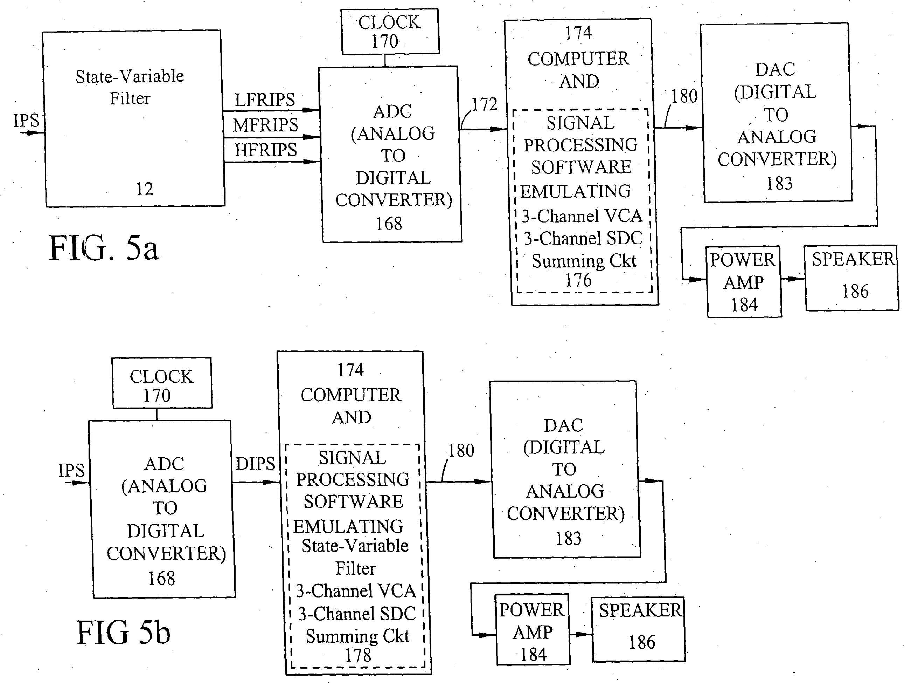

Figure 5a is a block diagram that shows a combination three channel state variable compressor circuit and process alternative to the analog process of Figures 1, 2, 3 and 4 for processing the IPS signal. The IPS is processed by the All-Pass State-Variable Filter 12 (Figures 1 and 2) to provide three FRIPS (Frequency Range Input Program Signal(s)). Each respective signal FIRPS is limited to a respective frequency range or band. As in the case of the analog circuit of Figure 1, 2, 3 and 4, the three signals include: a HFRIPS (High Frequency Range Input Program Signal), an MFRIPS (Mid-Frequency Range Input Program Signal), and a LFRIPS (Low-Frequency Range Input Program Signal). Each of the three FRIPS are then coupled to an ADC (Analog to Digital Converter) 168. Although the drawing shows a single ADC, it should be understood that each of the three signals could be sampled by a sequential commutator or multiplexer followed by a ADC or by a triad of sample and hold circuits each outputting a respective ADC circuit. As shown in Figure 5a, ADC 168 sequentially samples each of the three FRIPS. The ADC (analog to digital converter) input at the left of block 168 is coupled to receive, to sample and to convert the HFRIPS, the MFRIPS and the LFRIPS signals into a sequence of frames of DIPS (digitized input program signal) values. Each frame of DIPS values comprises the sampled value of a digitized HFRIPS, MFRIPS and LFRIPS signal acquired at a frame sample from three streams of DFRIPS (Digital Frequency Range Input Program Signal values). Each respective DFRIPS is limited to its respective frequency range by the pre-processing of the State-Variable Filter 12.

A continuous series of sets of three element values or frames of instantaneous values of the three FRIPS signals are provided by the ADC as digital values for each set or frame sample.

The sample rate is determined by a clock input from Clock 170. A minimum clock rate is typically 44 KHs. Conventional off the shelf ADCs can be clocked at twice that rate and higher rates are possible. The sampled values, are transferred to a bus 172 from which the values are transferred at interrupt times into computer 174 which is running signal processing software depicted as phantom block 176 or by components within the computer specifically designed for the signal processing task. Each emulated SDC within the signal process having an input coupled to receive, to scale, rectify and filter DFRIPS (Digital Frequency Range Input Program Signal) such as the HFRIPS, the MFRIPS and the LFRIPS and to provide a respective first, a second and a third DRGCS (Digital Range Gain Control Signal),

The signal processing software of block 176 is tailored to perform the function of the first, second and third SDC (Scaled Detector Circuit). Each SDC has an input coupled to receive a respective FRIPS, such as a respective HFRIPS, a MFRIPS or an LFRIPS. to scale, rectify and filter the FRIPS to provide a set of registers with a respective first, a second and a third digital values for their respective RGCS (Range Gain Control Signal).

Each emulated VCA within the signal process of block 176 has a digital signal input coupled to receive a respective DFRIPS, a respective control digital signal input coupled to receive a respective DRGCS, and a respective output to provide respective frames of digitized first, second and third DGCFRIPS (Digital Gain Controlled Frequency Range Input Program Signal) values. Each emulated VCA also has a respective register, operating as a VCA input, for receiving a series of digitized values of the control voltage representing a respective RGCS. The set of three emulated VCA outputs as a series of frames or slices of three value sets. Each frame contains the digitized and gain controlled amplitude values for the first, second and third GCFRIPS (Gain Controlled Frequency Range Input Program Signal).

The three values in each frame or slice are within a signal process that is a summing accumulator to provide a sample value of a COS (Composite Operating Signal) at a register or accumulator output. The summing Ckt process or emulation has a first second and third digital input. Each digital input is coupled to receive a respective DGCFRIP. After accumulating each the three values within each frame of data, the sum is output on signal line 180 to DAC 183. DAC 183 is a digital to analog converter that converts each DCOS value received in sequence into and analog COS (composite output signal).

The development of signal processing software 176 and or hardware such as LSI devices (not shown) is typically outsourced to software and component providers which will provide the software and or hardware from the specifications outlined for the analog equivalents of Figures 1 - 4.

Figure 5b shows a second and virtually all digital alternative embodiment of the analog circuits of Figures 1, 2, 3 and 4 that emulates the three channel state variable compressor process for operation in a digital computer or LSI device (not shown). In the block diagram of Figure 5b, the specification of the All-Pass State-Variable Filter 12 is added to the requirement for the software for use in the topology of Figure 5a, a step that results in a simplification of the topology to the of the product to be designed. Simplification is provided by the elimination of the analog version of the All-Pass State-Variable Filter 12 and its many discrete components.

An ADC (analog to digital converter) 168 has an input coupled to receive an IPS (input program signal). The ADC is characterized to provide a sequence of DIPS (digitized input program signal values), each DIPS characterizing the amplitude of the input program signal at a sample rate.

The signal processing hardware and or software in Figure 5b is represented by phantom block 178.

A first digital signal process or program for operation in a digital computer or LSI device emulates the all-pass state-variable filter 12 of Figures 1 and 2. The first digital process has an input coupled to receive and process a DIPS (Digital Input Signal) into three streams of DFRIPS (Digital Frequency Range Input Program Signal values). Each respective DFRIPS is limited to a respective frequency range. A second signal process emulates a first, second and third SDC (Scaled Detector Circuit). Each emulated SDC has an input coupled to receive a respective DFRIPS which it scales, rectifys and filters. The process then provides a respective first, a second and a third DRGCS (Digital Range Gain Control Signal).

A third signal process emulates a first second and third VCA (Voltage Control Amplifier). Each emulated VCA has a respective digital signal input coupled to receive a respective DFRIPS; a respective control digital signal input coupled to receive a respective DRGCS; and , a respective output to provide respective frames of digital first, second and third DGCFRIPS (Digital Gain Controlled Frequency Range Input Program Signal).

A fourth signal process emulates a summing circuit having a first second and third digital input. Each digital input is coupled to receive a respective DGCFRIP. The fourth signal process adds the first, second and third DGCFRIP in each set or frame to form a sequence of DCOS (Digital Composite Operating Signal) values. A digital to analog converter 183 then converts the sequence of DCOS values into and analog COS (composite output signal) for use by the power amplifier 184 and speaker 186.

In the embodiments of both Figures 5a and 5b, the Computer and or software outputs the emulated data on digital bus 180 to DAC (Digital To Analog Converter) 183. The analog output of the DAC is then coupled to the input of power amplifier 184 for delivery to speaker 186. If a clock is required for the operation of the DAC, it could be provided by clock 170 or by the computer as an enable signal.

While certain specific relationships, materials and other parameters have been detailed in the above description of preferred embodiments, those can be varied, where suitable, with similar results. Other applications, and variation of the present invention will occur to those skilled in the art upon reading the present disclosure. Those variations are also intended to be included within the scope of this invention as defined in the appended claims.

**Claims**

1. A three channel state variable compressor circuit comprising:

   an all-pass state-variable filter having an input coupled to receive and process an IPS (input program signal), into three FRIPS (Frequency Range Input Program Signal), each respective FRIPS being limited to a respective frequency range,
   a first, second and third SDC (Scaled Detector Circuit), each SDC having an input coupled to receive a respective FRIPS, to scale, rectify and filter the FRIPS to provide a respective first, a second and a third RGCS (Range Gain Control Signal),
   a first second and third VCA (Voltage Control Amplifier), each VCA having a respective signal input coupled to receive a respective FRIPS, a respective control voltage input coupled to receive a respective RGCS, and a respective output to provide a respective first, second and third GCFRIPS (Gain Controlled Frequency Range Input Program Signal), and
   a summing circuit having a first second and third input, each input being coupled to receive a respective GCFRIP, the summing amplifier adding the first, second and third GCFRIP to form and output a COS (Composite Operating Signal) at a Summing Circuit Output.

2. The three channel state variable compressor circuit of claim 1 wherein each of the first, second and third SDC (Scaled Detector Circuit(s)) each further comprises:

   a buffer amplifier having an input terminal coupled to receive a respective FRIPS and an output, the buffer amplifier providing amplification to buffer the FRIPS and to provide a respective BFRIPS (Buffered Frequency Range Input Program Signal).

3. The three channel state variable compressor circuit of claim 1 or claim 2 wherein each of the first, second and third SDC (Scaled Detector Circuit(s)) each further comprises:

   a detector and filter circuit, the detector and filter circuit being coupled to receive, rectify and filter the BFRIPS to provide a respective first, second and third RGCS (Range Gain Control Signal).

4. The three channel state variable compressor circuit of claim 1 wherein each of the first, second and third SDC (Scaled Detector Circuit(s)) each further comprises:

   a buffer amplifier having an input terminal coupled to receive a respective FRIPS and an output, the buffer amplifier providing amplification to buffer the FRIPS and to provide a respective BFRIPS (Buffered Frequency Range Input Program Signal), and
   a detector and filter circuit, the detector and filter circuit being coupled to receive, rectify and filter the BFRIPS to provide a respective first, second and third RGCS (Range Gain Control Signal).

5. The three channel state variable compressor circuit of any preceding claim wherein the All-Pass State-Variable Filter having an input coupled to receive and process an IPS (input program signal), into three FRIPS (Frequency Range Input Program Signal) further comprises:

   means for providing a HFRIPS (High Frequency Range Input Program Signal), an MFRIPS (Mid-Frequency Range Input Program Signal), and
   a LFRIPS (Low-Frequency Range Input Program Signal), the MFRIPS being formed at the output of a first integrator providing an odd stage of signal inversion, the LFRIPS and the HFRIPS having an even number of inversion stages.

6.   The three channel state variable compressor circuit of any preceding claim wherein each VCA (Voltage Control Amplifier) further comprises:

a type 2150A voltage controlled amplifier having a signal voltage input, a control voltage input and an output, the signal voltage input being coupled to receive a respective FRIPS, the control voltage input being coupled to a respective RGCS (Range Gain Control Signal) and its output providing a respective GCFRIPS, each GCFRIPS being coupled to a respective summing circuit input.

7.   The three channel state variable compressor circuit of any preceding claim wherein each VCA (Voltage Control Amplifier) further comprises:

an amplifier having at least a first and second gain control resistor, the first resistor being a light sensitive resistor **characterized** to have a lower value of resistance in response to light from an LED, the LED being driven by the RGCS, an increase in the value of the RGCS resulting in an increase in the light emitted by the LED followed by a corresponding change in the gain of the VCA.

8.   A three channel state variable compressor circuit comprising:

an all-pass state-variable filter having an input coupled to receive and process an IPS (input program signal) into a low frequency band signal, a middle frequency band signal and high frequency band Signal, the middle frequency band signal having an additional inversion stage with respect to the low frequency and high frequency band signals,
a first, second and third SDC (Scaled Detector Circuit), each SDC having an input coupled to receive a respective frequency band signal and an output, each SDC being **characterized** to buffer, rectify and filter its respective frequency band signal to form a control voltage at its output,
a first second and third VCA (Voltage Control Amplifier), each VCA having a respective signal input coupled to a respective frequency band signal and a control voltage input coupled to a respective control voltage at its respective SDC output, each VCA being **characterized** to reduce its gain in response to an increase in the control voltage applied to its control voltage input and to provide a respective GCFRIPS (Gain Controlled Frequency Range Input Program Signal), and
a summing circuit having a first second and third input, each input being coupled to receive a respective GCFRIPS, the summing amplifier adding the first, second and third GCFRIPs to provide a COS (Composite Operating Signal) at a Summing Circuit Output.

9.   The three channel state variable compressor circuit of claim 8 wherein each of the first, second and third SDC (Scaled Detector Circuit(s)) each further comprises:

a buffer amplifier having an input terminal coupled to receive a respective FRIPS and an output, the buffer amplifier providing amplification to buffer the FRIPS and to provide a respective BFRIPS (Buffered Frequency Range Input Program Signal).

10.  The three channel state variable compressor circuit of claim 8 wherein each of the first, second and third SDC (Scaled Detector Circuit(s)) each further comprises:

a buffer amplifier having an input terminal coupled to receive a respective FRIPS and an output, the buffer amplifier providing amplification to buffer the FRIPS and to provide a respective BFRIPS (Buffered Frequency Range Input Program Signal), and
a detector and filter circuit, the detector and filter circuit being coupled to receive, rectify and filter the BFRIPS to provide a respective first, second and third RGCS (Range Gain Control Signal).

11.  The three channel state variable compressor circuit of any one of claims 8 to 10 wherein the all-pass state-variable filter having an input coupled to receive and process an IPS (input program signal), into three FRIPS (Frequency Range Input Program Signal) further comprises:

means for providing a HFRIPS (High Frequency Range Input Program Signal), an MFRIPS (Mid-Frequency Range Input Program Signal), and
a LFRIPS (Low-Frequency Range Input Program Signal), the MFRIPS being formed at the output of a first integrator providing an odd stage of signal inversion, the LFRIPS and the HFRIPS having an even number of

**10**

inversion stages.

12. The three channel state variable compressor circuit of any one of claims 8 to 11 wherein each VCA (Voltage Control Amplifier) further comprises:

a type 2150A voltage controlled amplifier having a signal voltage input, a control voltage input and an output, the signal voltage input being coupled to receive a respective FRIPS, the control voltage input being coupled to a respective RGCS (Range Gain Control Signal) and its output providing a respective GCFRIPS, each GCFRIPS being coupled to a respective summing circuit input.

13. A three channel state variable compressor circuit comprising:

an all-pass state-variable filter having an input coupled to receive and process an IPS (input program signal), into three signals, each respective signal being limited to a respective frequency range, the three signals including:

a HFRIPS (High Frequency Range Input Program Signal),
an MFRIPS (Mid-Frequency Range Input Program Signal), and
a LFRIPS (Low-Frequency Range Input Program Signal),
a first, second and third VCA (Voltage Controlled Amplifier) circuit, each respective VCA having a signal input, a control signal input, and an output,
a SDC (Scaled Detector Circuit) means for sampling, scaling, rectifying and filtering the HFRIPS (High Frequency Range Input Program Signal), the MFRIPS (Mid-Frequency Range Input Program Signal), and the LFRIPS (Low-Frequency Range Input Program Signal) to provide
a respective HFRGCS (High-Frequency Range Gain Control Signal) to the first VCA control voltage input, an MFRGCS (Mid-Frequency Range Gain Control Signal) to the second VCA control voltage input, and a LFRGCS (Low-Frequency Range Gain Control Signal) to the third VCA control voltage input, the first second and third VCA (Voltage Control Amplifier), responding to their respective Gain Control Signals and respectively to the corresponding HFRIPS, the MFRIPS and the LFRIPS to provide
a GCHFRIPS (Gain Controlled High-Frequency Range Input Program Signal),
a GCMFRIPS (Gain Controlled Mid-Frequency Range Input Program Signal) and
a GCLFRIPS (Gain Controlled Low-Frequency Range Input Program Signal), a summing circuit having a first second and third input, each respective
summing circuit input being coupled to its corresponding VCA first, second and
third output to add and provide the sum of the GCHFRIPS, the GCMFRIPS and
the GCLFRIPS to provide a COS (Composite Operating Signal) at a Summing Circuit Output.

14. The Three Channel State Variable Compressor Circuit of claim 13 wherein The Summing Circuit comprises:

a summing circuit first input coupled to receive the GCHFRIPS,
a summing circuit second input coupled to receive the GCMFRIPS,
a summing circuit third input coupled to receive the GCLFRIPS
a summing circuit output terminal to output the COS,
an operational amplifier including:

an inverting input,
a non-inverting input coupled to ground, and

a first input resistor,
a second input resistor and
a third input resistor and
a feedback resistor,

each resistor having a respective first and second end,

the summing circuit first input being coupled to the first input resistor first end,
the summing circuit second input being coupled to the second input resistor first end,
the summing circuit third input being coupled to the third input resistor first end,

the feedback resistor first end being connected to the summing circuit output terminal,
the first input resistor second end, the second input resistor second end, the third input resistor second end and the feedback resistor second end each being connected to the operational amplifier inverting input,
the operational amplifier output terminal being coupled to the summing circuit output terminal to output the analog sum of the GCHFRIPS, the GCMFRIPS and the GCLFRIPS signals to provide the COS at the summing circuit output.

15. The Three Channel State Variable Compressor Circuit of claim 13 or claim 14 wherein the all-pass state-variable filter further comprises:

a first amplifier stage responsive to the IPS for providing the HFRIPS,
a second amplifier stage responsive to an output of the first amplifier stage for providing the MFRIPS, and
a third amplifier stage for providing the LFRIPS.

16. The Three Channel State Variable Compressor Circuit of any one of claims 13 to 15 wherein the MFRIPS is inverted in phase with respect to the HFRIPS and the LFRIPS signal components.

17. The Three Channel State Variable Compressor Circuit of any one of claims 13 to 16 wherein the all-pass state-variable filter further comprises:

an input summing and damping amplifier having a first input coupled to receive the IPS, a second input coupled to receive the LFRIPS, a third input coupled to receive the MFRIPS, the input summing and damping amplifier also having an output to provide the HFRIPS,
a first integrator having an input coupled to receive the HFRIPS from the input summing and damping amplifier output, the first integrator having an output providing the MFRIPS to the input summing and damping amplifier,
a second integrator having an input coupled to receive the MFRIPS from the first integrator output, the second integrator having an output providing the LFRIPS, and
the state-variable summing amplifier having a first, a second and a third input, the state-variable summing amplifier first input being coupled to receive the LFRIPS, the second input being coupled to receive the MFRIPS and the third input being coupled to receive the HFRIPS, the state-variable summing amplifier adding the respective LFRIPS, the MFRIPS and the HFRIPS to provide the COS at its output.

18. The Three Channel State Variable Compressor Circuit of claim 17 wherein the All-Pass State Variable Filter first integrator inverts the MFRIPS signal in phase with respect to the HFRIPS signal and the LFRIPS signal components.

19. A combination three channel state variable compressor circuit and process comprising:

an all-pass state-variable filter circuit having an input coupled to receive and process an IPS (input program signal), into three signal signals, each respective signal being limited to a respective frequency range, the three signals including:

a HFRIPS (High Frequency Range Input Program Signal),
an MFRIPS (Mid-Frequency Range Input Program Signal), and
a LFRIPS (Low-Frequency Range Input Program Signal),
an ADC (analog to digital converter) having an input coupled to receive, to sample and to convert the HFRIPS, the MFRIPS and the LFRIPS signals into a sequence of frames of DIPS (digitized input program signal) values, each frame of DIPS values comprising the sampled value of a digitized HFRIPS, MFRIPS and LFRIPS signal acquired at a frame sample from three streams of DFRIPS (Digital Frequency Range Input Program Signal values), each respective DFRIPS being limited to a respective frequency range,
a first signal process or program, which, when executing in a digital signal processor, is operative for emulating a first, second and third SDC (Scaled Detector Circuit), each emulated SDC within the signal process having an input coupled to receive a respective HFRIPS, a MFRIPS or an LFRIPS, to scale, rectify and filter the HFRIPS, the MFRIPS and the LFRIPS and to provide a respective first, a second and a third DRGCS (Digital Range Gain Control Signal),
a second signal process or program, which, when executing in said digital signal processor, is operative for emulating a first second and third VCA (Voltage Control Amplifier), each emulated VCA within the signal process having a respective digital signal input coupled to receive a respective DFRIPS, a respective control digital signal input coupled to receive a respective DRGCS, and a respective output to provide respective frames of digitized first, second and third DGCFRIPS (Digital Gain Controlled Frequency Range Input Program Signal) values, and

a third signal process or program, which, when executing in said digital signal processor, is operative for emulating a summing circuit having a first second and third digital input, each digital input being coupled to receive a respective DGCFRIP, the signal process adding the first, second and third DGCFRIP in each sample set or frame to form a sequence of DCOS (Digital Composite Operating Signal) values,

a digital to analog converter for converting the DCOS values into and analog COS (composite output signal).

**20.** A three channel state variable compressor process operating in a digital signal processor comprising:

an ADC (analog to digital converter) having an input coupled to receive an IPS (input program signal) and **characterized** to provide a sequence of DIPS (digitized input program signal values), each DIPS characterizing the amplitude of the input program signal at a sample rate,

a first digital signal process or program, which, when executing in said digital signal processor, is operative for for emulating an all-pass state-variable filter which has an input coupled to receive and process DIPS into three streams of DFRIPS (Digital Frequency Range Input Program Signal values), each respective DFRIPS being limited to a respective frequency range,

a second signal process or program, which, when executing in said digital signal processor; is operative for emulating a first, second and third SDC (Scaled Detector Circuit), each emulated SDC having an input coupled to receive a respective DFRIPS, to scale, rectify and filter the DFRIPS and to provide a respective first, a second and a third DRGCS (Digital Range Gain Control Signal),

a third signal process or program, which when executing in said digital signal processor, is operative for emulating a first second and third VCA (Voltage Control Amplifier), each emulated VCA having a respective digital signal input coupled to receive a respective DFRIPS, a respective control digital signal input coupled to receive a respective DRGCS, and a respective output to provide respective frames of digital first, second and third DGCFRIPS (Digital Gain Controlled Frequency Range Input Program Signal), and

a fourth signal process or program, which, when executing in said digital signal processor, is operative for emulating a summing circuit having a first second and third digital input, each digital input being coupled to receive a respective DGCFRIP, the a fourth signal process adding the first, second and third DGCFRIP in each set or frame to form a sequence of DCOS (Digital Composite Operating Signal) values,

a digital to analog converter for converting the sequence of DCOS values into and analog COS (composite output signal).

FIG. 1

EP 1 675 258 A1

FIG. 2

FIG. 3

FIG. 4

FIG. 5a

FIG 5b

EP 1 675 258 A1

**European Patent Office**

**EUROPEAN SEARCH REPORT**

Application Number

EP 05 25 7948

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/076072 A1 (CORNELISSE LEONARD E) 20 June 2002 (2002-06-20) * paragraphs [0002], [0010] - [0013], [0034] - [0038], [0049], [0050], [0054], [0059]; figures 3,7a,7b * | 1-20 | H03G9/02 |
| X | US 4 281 295 A (NISHIMURA ET AL) 28 July 1981 (1981-07-28) * column 1, lines 7-14 * * column 3, line 64 - column 5, line 2 * * column 7, line 67 - column 8, line 27 * * column 9, line 27 - column 12, line 29 * * column 13, line 11 - column 15, line 19 * * column 16, lines 57-68 * * figures 3,6a,8 * | 1-20 | |
| X | US 4 641 361 A (ROSBACK ET AL) 3 February 1987 (1987-02-03) * column 1, line 7 - column 6, line 64; figure 1 * | 1-20 | |
| X | EP 0 599 132 A (NOKIA TECHNOLOGY GMBH) 1 June 1994 (1994-06-01) * the whole document * | 1-20 | TECHNICAL FIELDS SEARCHED (IPC) H03G |
| D,A | US 5 736 897 A (GAGON ET AL) 7 April 1998 (1998-04-07) * column 3, lines 8-17 * * column 4, line 12 - column 7, line 67; figures 3,4 * | 1,8,13 | |
| A | US 4 934 770 A (ANDERSON ET AL) 19 June 1990 (1990-06-19) * column 12, line 59 - column 13, line 17; figures 3,13 * * column 20, line 54 - column 26, line 50 * | 1,8,13 | |

The present search report has been drawn up for all claims

| Place of search | Date of completion of the search | Examiner |
|---|---|---|
| The Hague | 22 March 2006 | Goethals, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**   EP 05 25 7948

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2006

| Patent document cited in search report | | Publication date | Patent family member(s) | | Publication date |
|---|---|---|---|---|---|
| US 2002076072 | A1 | 20-06-2002 | AU | 4278300 A | 10-11-2000 |
| | | | WO | 0065872 A1 | 02-11-2000 |
| | | | CA | 2372017 A1 | 02-11-2000 |
| | | | JP | 2002543703 T | 17-12-2002 |
| US 4281295 | A | 28-07-1981 | DE | 2838293 A1 | 08-03-1979 |
| | | | FR | 2402353 A1 | 30-03-1979 |
| | | | GB | 2003707 A | 14-03-1979 |
| | | | JP | 1362985 C | 09-02-1987 |
| | | | JP | 54039516 A | 27-03-1979 |
| | | | JP | 61028162 B | 28-06-1986 |
| US 4641361 | A | 03-02-1987 | CA | 1278525 C | 02-01-1991 |
| EP 0599132 | A | 01-06-1994 | DE | 69330935 D1 | 22-11-2001 |
| | | | DE | 69330935 T2 | 04-04-2002 |
| | | | DK | 599132 T3 | 03-12-2001 |
| | | | FI | 925283 A | 21-05-1994 |
| | | | JP | 6284095 A | 07-10-1994 |
| | | | US | 5485524 A | 16-01-1996 |
| US 5736897 | A | 07-04-1998 | CN | 1135682 A | 13-11-1996 |
| | | | DE | 69620664 D1 | 23-05-2002 |
| | | | DE | 69620664 T2 | 28-11-2002 |
| | | | EP | 0724329 A1 | 31-07-1996 |
| | | | JP | 8321735 A | 03-12-1996 |
| | | | US | 5510752 A | 23-04-1996 |
| US 4934770 | A | 19-06-1990 | NONE | | |

EPO FORM P0459

For more details about this annex : see Official Journal of the European Patent Office, No. 12/82